(19) Europäisches Patentamt
European Patent Office
Office européen des brevets

(11) EP 2 221 858 A1

(12) **EUROPEAN PATENT APPLICATION**
published in accordance with Art. 153(4) EPC

(43) Date of publication:
**25.08.2010 Bulletin 2010/34**

(21) Application number: **07850486.7**

(22) Date of filing: **12.12.2007**

(51) Int Cl.:
***H01L 21/336*** *(2006.01)* ***H01L 21/28*** *(2006.01)*
***H01L 29/78*** *(2006.01)*

(86) International application number:
**PCT/JP2007/073935**

(87) International publication number:
**WO 2009/075031 (18.06.2009 Gazette 2009/25)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Unisantis Electronics (Japan) Ltd.**
**Chuo-ku**
**Tokyo 104-0033 (JP)**

(72) Inventors:
- **MASUOKA, Fujio**
  **Tokyo 104-0033 (JP)**
- **KUDO, Tomohiko**
  **Tokyo 104-0033 (JP)**

(74) Representative: **Röthinger, Rainer**
**Wuesthoff & Wuesthoff**
**Patent- und Rechtsanwälte**
**Schweigerstrasse 2**
**81541 München (DE)**

# (54) SEMICONDUCTOR DEVICE

(57) It is intended to provide a semiconductor device capable of solving problems of increase in power consumption and lowering in operation speed due to an increase in parasitic resistance of a surrounding gate transistor (SGT) as a three-dimensional transistor, to achieve high-speed SGT operation and low power consumption. In order to achieve this object, the present invention provides a semiconductor device which comprises: a first silicon pillar formed on a semiconductor substrate; a second silicon pillar formed on the first silicon pillar; a first insulator surrounding a part of a surface of the second silicon pillar; a gate surrounding the first insulator; a third silicon pillar formed on the second silicon pillar; a first silicide surrounding a part of a surface of the first silicon pillar; and a second silicide surrounding a part of a surface of the third silicon pillar, wherein each of a contact resistance formed by the first silicide and the first silicon pillar, and a contact resistance formed by the second silicide and the third silicon pillar, is less than a reference resistance of the semiconductor device.

FIG. 2

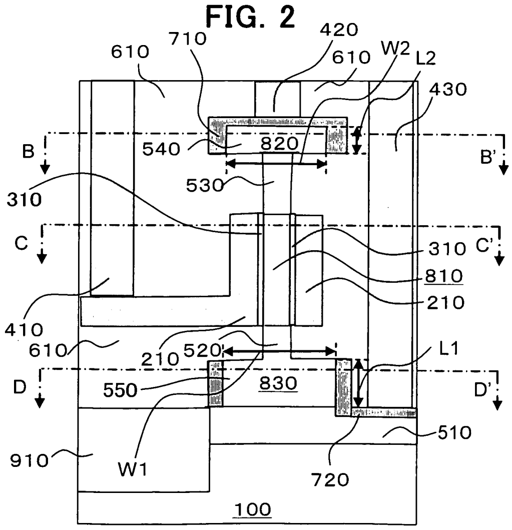


EP 2 221 858 A1

## Description

TECHNICAL FIELD

The present invention relates to a semiconductor device, and more specifically to a semiconductor device having a surrounding gate transistor (SGT) which is a three-dimensional semiconductor.

BACKGROUND ART

Through miniaturization of semiconductor devices using a planar transistor, the planar transistor is used in a wide range of fields, such as computers, communication devices, measurement devices, automatic control devices and domestic devices, as a low-power consumption, low-cost, high-throughput microprocessor, an ASIC, a microcomputer, and a low-cost, large-capacity memory. However, the planar transistor is two-dimensionally formed on a plane of a semiconductor substrate. Specifically, the planar transistor has a structure where a source, a gate and a drain thereof are arranged along a surface of a silicon substrate in a horizontal direction. In contrast, the SGT has a structure where a source, a gate and a drain thereof are arranged in a direction perpendicular to a surface of a silicon substrate while allowing the gate to surround a convex-shaped semiconductor layer (see, for example, FIG. 20 in the following Non-Patent Document 1). Therefore, the SGT can largely reduce an occupancy area as compared with the planar transistor. However, in the SGT, along with miniaturization of ultra-large-scale integrated circuits (ULSI), a gate length becomes shorter to provide a lower channel resistance, whereas, as a silicon pillar becomes miniaturized, a diffusion-layer resistance and a contact resistance, i.e., a parasitic resistance, become larger to cause a reduction in drive current. Thus, in a miniaturized SGT device, it is essential to further reduce a parasitic resistance.

There has been known a technique of reducing a contact resistance as a parasitic resistance of source and drain regions to achieve a higher-speed operation of the device, as disclosed, for example, in the following Patent Document 1. FIG. 21 shows an SGT structure disclosed in the Patent Document 1, which is intended to reduce the contact resistance. In an SGT, along with scaling down of a silicon pillar, a contact area between the silicon pillar and a contact to be connected to a top of the silicon pillar becomes smaller to cause an increase in contact resistance. Consequently, a drive current of the SGT is reduced. As measures against this problem, the Patent Document 1 discloses a structure for increasing the contact area between the silicon pillar and the contact so as to reduce the contact resistance. Specifically, the structure is configured to allow the contact to come into contact with not only a top surface of the silicon pillar but also a part of a side surface of the silicon pillar, so that the contact area between the silicon pillar and the contact is increased to reduce the contact resistance.

[Non-Patent Document 1] H.Takato et al., IEEE transaction on electron device, Vol. 38, No. 3, March 1991, pp 573-578

[Patent Document 1] JP 2007-123415A

DISCLOSURE OF THE INVENTION

[PROBLEM TO BE SOLVED BY THE INVENTION]

As an SGT structure for reducing the contact resistance, the Patent Document 1 proposes a structure where the contact area between the silicon pillar and the contact is set to become greater than an area of the top surface of the silicon pillar, to reduce the contact resistance. However, in order to actually achieve a higher-speed operation of an SGT constituting a ULSI, it is desirable that the contact resistance is less than a reference resistance of the SGT.

In view of the above circumstances, it is an object of the present invention to provide a semiconductor device capable of reducing a contact resistance as a parasitic resistance to solve the problem of lowering in operation speed of an SGT.

[MEANS FOR SOLVING THE PROBLEM]

In order to achieve the above object, according to a first aspect of the present invention, there is provided a semiconductor device which comprises: a first silicon pillar formed on a semiconductor substrate; a second silicon pillar formed on the first silicon pillar; a first insulator surrounding a part of a surface of the second silicon pillar; a gate surrounding the first insulator; a third silicon pillar formed on the second silicon pillar; a first silicide surrounding a part of a surface of the first silicon pillar; and a second silicide surrounding a part of a surface of the third silicon pillar, wherein each of a contact resistance formed by the first silicide and the first silicon pillar, and a contact resistance formed by the second silicide and the third silicon pillar, is less than a reference resistance of the semiconductor device.

According to a second aspect of the present invention, there is provided a semiconductor device which comprises: a second silicon pillar formed on a semiconductor substrate; a first insulator surrounding a part of a surface of

the second silicon pillar; a gate surrounding the first insulator; a third silicon pillar formed on the second silicon pillar; and a second silicide surrounding a part of a surface of the third silicon pillar, wherein a contact resistance formed by the second silicide and the third silicon pillar is less than a reference resistance of the semiconductor device.

According to a third aspect of the present invention, there is provided a semiconductor device which comprises: a first silicon pillar formed on a semiconductor substrate; a second silicon pillar formed on the first silicon pillar; a first insulator surrounding a part of a surface of the second silicon pillar; a gate surrounding the first insulator; and a first silicide surrounding a part of a surface of the first silicon pillar, wherein a contact resistance formed by the first silicide and the first silicon pillar is less than a reference resistance of the semiconductor device.

As above, the present invention makes it possible to reduce a parasitic resistance of a semiconductor device element to provide a semiconductor device having a high-speed, low-power consumption ULSI.

BRIEF DESCRIPTION OF THE DRAWINGS

FIG. 1 is a bird's-eye view showing a semiconductor device according to a first embodiment of the present invention.
FIG. 2 is a sectional view of the semiconductor device, taken along the line A-A' in FIG. 1.
FIG. 3 is a top view of the semiconductor device in FIG. 1.
FIG. 4 is a sectional view of the semiconductor device, taken along the line B-B' in FIG. 2.
FIG. 5 is a sectional view of the semiconductor device, taken along the line C-C' in FIG. 2.
FIG. 6 is a sectional view of the semiconductor device, taken along the line D-D' in FIG. 2.
FIG. 7 is a graph showing a relationship between a diameter W1 and a length L1 of a first silicon pillar 830 for satisfying a condition that a contact resistance formed by a silicide and the first silicon pillar 830 is less than a reference resistance in the semiconductor device in FIG. 1.
FIG. 8 is a graph showing a relationship between a diameter W2 and a length L2 of a third silicon pillar 820 for satisfying a condition that a contact resistance formed by a silicide and the third silicon pillar 820 is less than a reference resistance in the semiconductor device in FIG. 1.
FIG. 9 is a bird's-eye view showing a semiconductor device according to a second embodiment of the present invention.
FIG. 10 is a sectional view of the semiconductor device, taken along the line A-A' in FIG. 9.
FIG. 11 is a top view of the semiconductor device in FIG. 9.
FIG. 12 is a sectional view of the semiconductor device, taken along the line B-B' in FIG. 10.
FIG. 13 is a sectional view of the semiconductor device, taken along the line C-C' in FIG. 10.
FIG. 14 is a graph showing a relationship between a diameter W2 and a length L2 of a third silicon pillar 820 for satisfying a condition that a contact resistance formed by a silicide and the third silicon pillar 820 is less than a reference resistance in the semiconductor device in FIG. 9.
FIG. 15 is a bird's-eye view showing a semiconductor device according to a third embodiment of the present invention.
FIG. 16 is a sectional view of the semiconductor device, taken along the line A-A' in FIG. 15.
FIG. 17 is a top view of the semiconductor device in FIG. 15.
FIG. 18 is a sectional view of the semiconductor device, taken along the line B-B' in FIG. 16.
FIG. 19 is a sectional view of the semiconductor device, taken along the line C-C' in FIG. 16.
FIG. 20 is a graph showing a relationship between a diameter W1 and a length L1 of a first silicon pillar 830 for satisfying a condition that a contact resistance formed by a silicide and the first silicon pillar 830 is less than a reference resistance in the semiconductor device in FIG. 1.
FIG. 21 is a bird's-eye view showing one example of a conventional SGT.
FIG. 22 is a top view of the conventional SGT.
FIG. 23 is a sectional view of the conventional SGT, taken along the line I-I' in FIG. 22.

BEST MODE FOR CARRYING OUT THE INVENTION

With reference to the drawings, a semiconductor device of the present invention will now be specifically described.

FIRST EMBODIMENT: Semiconductor Device

FIG. 1 is a schematic bird's-eye view showing a transistor of a semiconductor device according to a first embodiment of the present invention. FIG. 2 is a schematic sectional view taken along the line A-A' in FIG. 1, and FIG. 3 is a top view of the transistor in FIG. 1. FIG. 4, FIG. 5 and FIG. 6 are a schematic sectional view taken along the line

B-B' in FIG. 2, a schematic sectional view taken along the line C-C' in FIG. 2, and a schematic sectional view taken along the line D-D' in FIG. 2, respectively. The semiconductor device according to the first embodiment comprises: a first silicon pillar 830 formed on a first conductive-type semiconductor substrate 100 to have a cross-sectionally circular shape; a second silicon pillar 810 formed on the first silicon pillar 830 to have a cross-sectionally circular shape; a first insulator 310 surrounding a part of a surface of the second silicon pillar 810; a gate 210 surrounding the first insulator 310; and a third silicon pillar 820 formed on the second silicon pillar 810 to have a cross-sectionally circular shape.

The second silicon pillar 810 includes a second conductive-type high-concentration impurity region 520 formed as a part of the second silicon pillar 810, and a second conductive-type high-concentration impurity region 530 formed as a part of the second silicon pillar 810.

The semiconductor substrate 100 includes a second conductive-type high-concentration impurity region 510 formed as a part of the semiconductor substrate 100, and a silicide region (first silicide) 720 formed as a part of the high-concentration impurity region 510. The semiconductor substrate 100 also has an element isolation region 910 formed therein.

The third silicon pillar 820 includes a second conductive-type high-concentration impurity region 540 formed as a part of the third silicon pillar 820, and a silicide region (second silicide) 710 is formed in the high-concentration impurity region 540.

The first silicon pillar 830 includes a second conductive-type high-concentration impurity region 550 formed as a part of the first silicon pillar 830.

The semiconductor device according to the first embodiment further comprises a contact 430 formed on the silicide region 720, a contact 420 formed on the silicide region 710, and a contact 410 formed on the gate 210.

Each of a contact resistance R1 formed by the first silicon pillar 830 including the high-concentration impurity region 510 and the silicide region 720 formed in the first silicon pillar 830, and a contact resistance R2 formed by the third silicon pillar 820 including the high-concentration impurity region 540 and the silicide region 710 formed in the third silicon pillar 830, is a parasitic resistance. In order to reduce the parasitic resistance, it is preferable that the contact resistances R1, R2 satisfy the following relational formulas (1-1), (1-2) with respect to a reference resistance Rs:

$$R1 < Rs \qquad (1\text{-}1)$$

$$R2 < Rs \qquad (1\text{-}2)$$

The reference resistance Rs is calculated according to the following formula (1-3) based on a current I (A) which flows between the contact 410 and the contact 430 in the above semiconductor device when 0 (V) is applied to one of the contacts 410, 430 and V (V) is applied to a remaining one of the contacts 410, 430, while applying V (V) to the contact 420, under a condition that the contact resistance R1 = 0 and the contact resistance R2 = 0:

$$Rs = V / I \qquad (1\text{-}3)$$

Specifically, when a length of the gate 210, a film thickness of the gate oxide layer, and a diameter of the second silicon pillar 810, are, respectively, 20 nm, 1 nm, and 10 nm, the parasitic resistance R1 of the first silicon pillar 830, a contact resistivity $\rho_C$, a sheet resistance $\rho_D$ of a first conductive-type impurity region, a circumferential length K1 of a cross-section of the first silicon pillar 830, and a height dimension L1 of the first silicon pillar 830, satisfy the following formula (1-4), wherein $\alpha$ is expressed as the formula (1-5). Further, given that the circumferential length K1 (cm) of the cross-section of the first silicon pillar 830 satisfies the following relational formula (1-6) with respect to a diameter W1 (cm) of the first silicon pillar 830.

$$R1 = \frac{\rho_C}{\alpha K1}\coth\left(\frac{L1}{\alpha}\right) \qquad (1\text{-}4)$$

$$\alpha = \left( \frac{\rho_C}{\rho_D} \right)^{\frac{1}{2}} \quad (1\text{-}5)$$

$$K1 = \pi W1 \quad (1\text{-}6)$$

The parasitic resistance R2 of the third silicon pillar 820, a contact resistivity $\rho_C$, a sheet resistance $\rho_D$ of a first conductive-type impurity region, a circumferential length K2 of a cross-section of the third silicon pillar 820, and a height dimension L2 of the third silicon pillar 820, satisfy the following formula (1-7). Further, given that the circumferential length K2 (cm) of the cross-section of the third silicon pillar 820 satisfies the following relational formula (1-8) with respect to a diameter W2 (cm) of the third silicon pillar 820.

$$R2 = \frac{\rho_C}{\alpha K2} \coth\left( \frac{L2}{\alpha} \right) \quad (1\text{-}7)$$

$$K2 = \pi W2 \quad (1\text{-}8)$$

The formula (1-4) is assigned to the formula (1-1), and the formula (1-7) is assigned to the formula (1-2), to obtain the following conditional formulas (1-9), (1-10):

$$\frac{\rho_C}{\alpha K1} \coth\left( \frac{L1}{\alpha} \right) < R_s \quad (1\text{-}9)$$

$$\frac{\rho_C}{\alpha K2} \coth\left( \frac{L2}{\alpha} \right) < R_s \quad (1\text{-}10)$$

As one example, given that the contact resistivity $\rho_C$ and the sheet resistance $\rho_D$ are, respectively, 6.2e-8 ($\Omega$-$cm^2$) and 6.4e-3/W1 ($\Omega$/sq.), and the current I (A) flowing between the contact 410 and the contact 430 in the above semiconductor device is 44 ($\mu$A) when 0 (V) is applied to one of the contacts 410, 430 and 1 (V) is applied to a remaining one of the contacts 410, 430, while applying 1 (V) to the contact 420, the reference resistance Rs is calculated as 2.3e-8 ($\Omega$) according to the formula (1-3). These values are assigned to the formulas (1-9), (1-10) to obtain the following relational formula (1-11) between the height dimension L1 of the first silicon pillar 830 and the circumferential length K1 of the cross-section of the first silicon pillar 830, and the following relational formula (1-12) between the height dimension L2 (cm) of the third silicon pillar 820 and the circumferential length K2 (cm) of the cross-section of the third silicon pillar 820:

$$\frac{1}{W1^{3/2}}\coth\left(\frac{L1}{W1^{1/2}\cdot 3.1e-3}\right)<3.6e9 \qquad (1\text{-}11)$$

$$\frac{1}{W2^{3/2}}\coth\left(\frac{L2}{W2^{1/2}\cdot 3.1e-3}\right)<3.6e9 \qquad (1\text{-}12)$$

If these conditional formulas (1-11), (1-12) are satisfied, the formulas (1-1) are satisfied. Thus, the following formulas (1-13), (1-14) are obtained (see FIGS. 7 and 8):

$$\frac{1}{W1^{3/2}}\coth\left(\frac{L1}{W1^{1/2}\cdot 3.1e-3}\right)<3.6e9 \Rightarrow R1<Rs \qquad (1\text{-}13)$$

$$\frac{1}{W2^{3/2}}\coth\left(\frac{L2}{W2^{1/2}\cdot 3.1e-3}\right)<3.6e9 \Rightarrow R2<Rs \qquad (1\text{-}14)$$

As another example, given that a circumferential length of the second silicon pillar 810, each of the circumferential lengths of the third and first silicon pillars 820, 830 and the gate length are set, respectively, in the range of 8 nm to 100 μm, in the range of 8 nm to 100 μm and in the range of 6 nm to 10 μm. Further, given that the diameter of the second silicon pillar 810, the contact resistivity $\rho_C$ and the sheet resistance $\rho_D$ are, respectively, 2.6 nm, 7e-9 (Ω-cm$^2$) and 6.4e-3/W1 (Ω/sq.), and the current I (A) flowing between the contact 410 and the contact 430 in the above semiconductor device is 11.4 (μA) when 0 (V) is applied to one of the contacts 410, 430 and 1 (V) is applied to a remaining one of the contacts 410, 430, while applying 1 (V) to the contact 420, the reference resistance Rs is calculated as 9.0e-8 (Ω) according to the formula (1-3). These values are assigned to the formulas (1-8), (1-9) to obtain the following formulas (1-15), (1-16):

$$\frac{1}{W1^{3/2}}\coth\left(\frac{L1}{W1^{1/2}\cdot 1.1e-3}\right)<4.3e10 \qquad (1\text{-}15)$$

$$\frac{1}{W2^{3/2}}\coth\left(\frac{L2}{W2^{1/2}\cdot 1.1e-3}\right)<4.3e10 \qquad (1\text{-}16)$$

If these conditional formulas (1-15), (1-16) are satisfied, the formulas (1-1), (1-2) are satisfied. Thus, the following formulas (1-17), (1-18) are obtained:

$$\frac{1}{W1^{3/2}}\coth\left(\frac{L1}{W1^{1/2}\cdot 1.1e-3}\right) < 4.3e10 \Rightarrow R1 < Rs \qquad (1\text{-}17)$$

$$\frac{1}{W2^{3/2}}\coth\left(\frac{L2}{W2^{1/2}\cdot 1.1e-3}\right) < 4.3e10 \Rightarrow R2 < Rs \qquad (1\text{-}18)$$

SECOND EMBODIMENT: Semiconductor Device

FIG. 9 is a schematic bird's-eye view showing a transistor of a semiconductor device according to a second embodiment of the present invention. FIG. 10 is a schematic sectional view taken along the line A-A' in FIG. 9, and FIG. 11 is a top view of the transistor in FIG. 9. FIG. 12 is a schematic sectional view taken along the line B-B' in FIG. 10, and FIG. 13 is a schematic sectional view taken along the line C-C' in FIG. 10. The semiconductor device according to the second embodiment comprises a second silicon pillar 810 formed on a first conductive-type semiconductor substrate 100 to have a cross-sectionally circular shape, and a third silicon pillar 820 formed on the second silicon pillar 810 to have a cross-sectionally circular shape.

A part of a surface of the second silicon pillar 810 is surrounded by a first insulator 310, and the first insulator 310 is surrounded by a gate 210. The second silicon pillar 810 includes a second conductive-type high-concentration impurity region 520 formed as a part of the second silicon pillar 810, and a second conductive-type high-concentration impurity region 530 formed as a part of the second silicon pillar 810.

The semiconductor substrate 100 includes a second conductive-type high-concentration impurity region 510 formed as a part of the semiconductor substrate 100, and a silicide region (first silicide) 720 formed as a part of the high-concentration impurity region 510. The semiconductor substrate 100 also has an element isolation region 910 formed therein.

The third silicon pillar 820 includes a second conductive-type high-concentration impurity region 540 formed as a part of the third silicon pillar 820, and a silicide region (second silicide) 710 is formed in the high-concentration impurity region 540.

The semiconductor device according to the second embodiment further comprises a contact 430 formed on the silicide region 720, a contact 420 formed on the silicide region 710, and a contact 410 formed on the gate 210.

Differently from the first embodiment, on an assumption that a contact resistance R1 formed by the semiconductor substrate 100 including the high-concentration impurity region 510 and the silicide region 720 formed in the semiconductor substrate 100 is ignorable, the structure in the second embodiment is designed to satisfy the following formula (2-1):

$$R1 \ll Rs, R1 \ll R2 \qquad (2\text{-}1)$$

In this case, in order to reduce a contact resistance or parasitic resistance R2 formed by the third silicon pillar 820 including the high-concentration impurity region 540 and the silicide region 710 formed in the third silicon pillar 830, it is preferable that the contact resistance R2 and a reference resistance Rs satisfy the following formula (2-2):

$$R2 < Rs \qquad (2\text{-}2)$$

The reference resistance Rs is calculated according to the following formula (2-3) based on a current I (A) which flows between the contact 410 and the contact 430 in the above semiconductor device when 0 (V) is applied to one of the contacts 410, 430 and V (V) is applied to a remaining one of the contacts 410, 430, while applying V (V) to the contact 420, under a condition that the contact resistance R1 = 0 and the contact resistance R2 = 0:

$$Rs = V / I \qquad (2\text{-}3)$$

Specifically, when a length of the gate 210, a film thickness of the gate oxide layer, and a diameter of the second silicon pillar 810, are, respectively, 20 nm, 1 nm, and 10 nm, the contact resistance R of the third silicon pillar 820, a contact resistivity $\rho_C$, a sheet resistance $\rho_D$ of a first conductive-type impurity region, a circumferential length K2 of a cross-section of the third silicon pillar 820, and a height dimension L2 of the third silicon pillar 820, satisfy the following formula (2-4), wherein $\alpha$ is expressed as the formula (2-5). Further, given that the circumferential length K2 (cm) of the cross-section of the third silicon pillar 820 satisfies the following relational formula (2-6) with respect to a diameter W2 (cm) of the third silicon pillar 820.

$$R2 = \frac{\rho_C}{\alpha K2} \coth\left(\frac{L2}{\alpha}\right) \qquad (2\text{-}4)$$

$$\alpha = \left(\frac{\rho_C}{\rho_D}\right)^{\frac{1}{2}} \qquad (2\text{-}5)$$

$$K2 = \pi W2 \qquad (2\text{-}6)$$

The formula (2-4) is assigned to the formula (2-1) to obtain the following conditional formulas (2-7):

$$\frac{\rho_C}{\alpha K2} \coth\left(\frac{L2}{\alpha}\right) < R_s \qquad (2\text{-}7)$$

As one example, given that the contact resistivity $\rho_C$ and the sheet resistance $\rho_D$ are, respectively, 6.2e-8 ($\Omega$-cm$^2$) and 6.4e-3/W1 ($\Omega$/sq.), and the current I (A) flowing between the contact 410 and the contact 430 in the above semiconductor device is 44 ($\mu$A) when 0 (V) is applied to one of the contacts 410, 430 and 1 (V) is applied to a remaining one of the contacts 410, 430, while applying 1 (V) to the contact 420, the reference resistance Rs is calculated as 2.3e-8 ($\Omega$) according to the formula (2-3). These values are assigned to the formula (2-7) to obtain the following relational formula (2-8) between the height dimension L2 (cm) of the third silicon pillar 820 and the circumferential length K2 (cm) of the cross-section of the third silicon pillar 820:

$$\frac{1}{W2^{3/2}} \coth\left(\frac{L2}{W2^{1/2} \cdot 3.1e-3}\right) < 3.6e9 \qquad (2\text{-}8)$$

If the conditional formula (2-8) is satisfied, the formula (2-1) is satisfied. Thus, the following formula (2-9) is obtained (see FIG. 14):

$$\frac{1}{W2^{3/2}}\coth\left(\frac{L2}{W2^{1/2}\cdot 3.1e-3}\right)<3.6e9 \Rightarrow R2<Rs \qquad (2\text{-}9)$$

As another example, given that a circumferential length of each of the second and first silicon pillars 810, 830, the circumferential length of the third silicon pillar 820 and the gate length are set, respectively, in the range of 8 nm to 100 μm, in the range of 8 nm to 100 μm and in the range of 6 nm to 10 μm. Further, given that the diameter of the second silicon pillar 810, the contact resistivity $\rho_C$ and the sheet resistance $\rho_D$ are, respectively, 2.6 nm, 7e-9 (Ω-cm$^2$) and 6.4e-3/W1 (Ω/sq.), and the current I (A) flowing between the contact 410 and the contact 430 in the above semiconductor device is 11.4 (μA) when 0 (V) is applied to one of the contacts 410, 430 and 1 (V) is applied to a remaining one of the contacts 410, 430, while applying 1 (V) to the contact 420, the reference resistance Rs is calculated as 9.0e-8 (Ω) according to the formula (2-3). Thus, the formula (2-7) is expressed as the following formula (2-10):

$$\frac{\rho_C}{\alpha K2}\coth\left(\frac{L2}{\alpha}\right)<R_s \qquad (2\text{-}10)$$

The above values are assigned to the formula (2-10) to obtain the following formula (2-11):

$$\frac{1}{W2^{3/2}}\coth\left(\frac{L2}{W2^{1/2}\cdot 1.1e-3}\right)<4.3e10 \qquad (2\text{-}11)$$

If the conditional formula (2-11) is satisfied, the formula (2-1) is satisfied. Thus, the following formula (2-12) is obtained:

$$\frac{1}{W2^{3/2}}\coth\left(\frac{L2}{W2^{1/2}\cdot 1.1e-3}\right)<4.3e10 \Rightarrow R2<Rs \qquad (2\text{-}12)$$

THIRD EMBODIMENT: Semiconductor Device

FIG. 15 is a schematic bird's-eye view showing a transistor of a semiconductor device according to a third embodiment of the present invention. FIG. 16 is a schematic sectional view taken along the line A-A' in FIG. 15, and FIG. 17 is a top view of the transistor in FIG. 14 FIG. 18 is a schematic sectional view taken along the line B-B' in FIG. 15and FIG. 19 is a schematic sectional view taken along the line C-C' in FIG. 15. The semiconductor device according to the third embodiment comprises: a first silicon pillar 830 formed on a first conductive-type semiconductor substrate 100 to have a cross-sectionally circular shape; a second silicon pillar 810 formed on the first silicon pillar 830 to have a cross-sectionally circular shape; a first insulator 310 surrounding a part of a surface of the second silicon pillar 810; a gate 210 surrounding the first insulator 310; and a third silicon pillar 820 formed on the second silicon pillar 810 to have a cross-sectionally circular shape.

The second silicon pillar 810 includes a second conductive-type high-concentration impurity region 520 formed as a part of the second silicon pillar 810, and a second conductive-type high-concentration impurity region 530 formed as a part of the second silicon pillar 810.

The semiconductor substrate 100 includes a second conductive-type high-concentration impurity region 510 formed as a part of the semiconductor substrate 100, and a silicide region (first silicide) 720 formed as a part of the high-concentration impurity region 510. The semiconductor substrate 100 also has an element isolation region 910 formed therein.

The third silicon pillar 820 includes a second conductive-type high-concentration impurity region 540 formed as a part of the third silicon pillar 820, and a silicide region (second silicide) 710 is formed in the high-concentration impurity region 540.

The first silicon pillar 830 includes a second conductive-type high-concentration impurity region 550 formed as a part of the first silicon pillar 830.

The semiconductor device according to the third embodiment further comprises a contact 430 formed on the silicide region 720, a contact 420 formed on the silicide region 710, and a contact 410 formed on the gate 210.

Differently from the first embodiment, on an assumption that a contact resistance R2 formed by the third silicon pillar 820 including the high-concentration impurity region 540 and the silicide region 710 formed in the third silicon pillar 830 is ignorable, the structure in the third embodiment is designed to satisfy the following formula (3-1):

$$R2 << Rs, R2 << Rs \qquad (3\text{-}1)$$

In this case, in order to reduce a contact resistance or parasitic resistance R1 formed by the first silicon pillar 830 including the high-concentration impurity region 510 and the silicide region 720 formed in the first silicon pillar 830, it is preferable that the contact resistance R1 and a reference resistance Rs satisfy the following formula (3-2):

$$R1 < Rs \qquad (3\text{-}2)$$

The reference resistance Rs is calculated according to the following formula (3-3) based on a current I (A) which flows between the contact 410 and the contact 430 in the above semiconductor device when 0 (V) is applied to one of the contacts 410, 430 and V (V) is applied to a remaining one of the contacts 410, 430, while applying V (V) to the contact 420, under a condition that the contact resistance R1 = 0 and the contact resistance R2 = 0:

$$Rs = V / I \qquad (3\text{-}3)$$

Specifically, when a length of the gate 210, a film thickness of the gate oxide layer, and a diameter of the second silicon pillar 810, are, respectively, 20 nm, 1 nm, and 10 nm, the contact resistance R1 of the first silicon pillar 830, a contact resistivity $\rho_C$, a sheet resistance $\rho_D$ of a first conductive-type impurity region, a circumferential length K1 of a cross-section of the first silicon pillar 830, and a height dimension L1 of the first silicon pillar 830, satisfy the following formula (3-4), wherein $\alpha$ is expressed as the formula (3-5). Further, given that the circumferential length K1 (cm) of the cross-section of the first silicon pillar 830 satisfies the following relational formula (3-6) with respect to a diameter W1 (cm) of the first silicon pillar 830.

$$R1 = \frac{\rho_C}{\alpha K1} \coth\left(\frac{L1}{\alpha}\right) \qquad (3\text{-}4)$$

$$\alpha = \left(\frac{\rho_C}{\rho_D}\right)^{\frac{1}{2}} \qquad (3\text{-}5)$$

$$K1 = \pi W1 \qquad (3\text{-}6)$$

The formula (3-4) is assigned to the formula (3-1) to obtain the following conditional formula (3-7):

$$\frac{\rho_C}{\alpha K1}\coth\left(\frac{L1}{\alpha}\right) < R_s \qquad (3\text{-}7)$$

As one example, given that the contact resistivity $\rho_C$ and the sheet resistance $\rho_D$ are, respectively, 6.2e-8 ($\Omega$-cm$^2$) and 1.6e-3 $\times$ 4/W1 ($\Omega$/sq.), and the current I (A) flowing between the contact 410 and the contact 430 in the above semiconductor device is 44 ($\mu$A) when 0 (V) is applied to one of the contacts 410, 430 and 1 (V) is applied to a remaining one of the contacts 410, 430, while applying 1 (V) to the contact 420, the reference resistance Rs is calculated as 2.3e-8 ($\Omega$) according to the formula (3-3). These values are assigned to the formula (3-7) to obtain the following relational formula (3-8) between the height dimension L1 of the first silicon pillar 830 and the circumferential length K1 of the cross-section of the first silicon pillar 830:

$$\frac{1}{W1^{3/2}}\coth\left(\frac{L1}{W1^{1/2}\cdot 3.1e-3}\right) < 3.6e9 \qquad (3\text{-}8)$$

If the conditional formula (3-8) is satisfied, the formula (3-1) is satisfied. Thus, the following formula (3-9) is obtained (see FIG. 20):

$$\frac{1}{W1^{3/2}}\coth\left(\frac{L1}{W1^{1/2}\cdot 3.1e-3}\right) < 3.6e9 \Rightarrow R1 < Rs \qquad (1\text{-}13)$$

As another example, given that a circumferential length of each of the second and third silicon pillars 810, 820, the circumferential length of the first silicon pillar 830 and the gate length are set, respectively, in the range of 8 nm to 100 $\mu$m, in the range of 8 nm to 100 $\mu$m and in the range of 6 nm to 10 $\mu$m. Further, given that the diameter of the second silicon pillar 810, the contact resistivity $\rho_C$ and the sheet resistance $\rho_D$ are, respectively, 2.6 nm, 7e-9 ($\Omega$-cm$^2$) and 1.6e-3 $\times$ 4/W1 ($\Omega$/sq.), and the current I (A) flowing between the contact 410 and the contact 430 in the above semiconductor device is 11.4 ($\mu$A) when 0 (V) is applied to one of the contacts 410, 430 and 1 (V) is applied to a remaining one of the contacts 410, 430, while applying 1 (V) to the contact 420, the reference resistance Rs is calculated as 9e-8 ($\Omega$) according to the formula (3-3). Further, given that L1 = L2 and K1 = K2, the following formula (3-10) is obtained:

$$\frac{\rho_C}{\alpha K1}\coth\left(\frac{L1}{\alpha}\right) < R_s \qquad (3\text{-}10)$$

The above values are assigned to the formula (3-10) to obtain the following formula (3-11):

$$\frac{1}{W1^{3/2}}\coth\left(\frac{L1}{W1^{1/2}\cdot 1.1e-3}\right) < 4.3e10 \qquad (3\text{-}11)$$

If the conditional formula (3-11) is satisfied, the formula (3-1) is satisfied. Thus, the following formula (3-12) is obtained:

$$\frac{1}{W1^{3/2}}\coth\left(\frac{L1}{W1^{1/2}\cdot 1.1e-3}\right) < 4.3e10 \Rightarrow R1 < Rs \qquad (3\text{-}12)$$

In the first to third embodiments, each of the first silicide region 710 and the second silicide region 720 may be made of one selected from the group consisting of nickel (Ni) silicide, platinum (Pt) silicide, erbium (Er) silicide, ytterbium (Yb) silicide and a combination of two or more thereof.

As mentioned above, the present invention provides a semiconductor device which comprises: a first silicon pillar formed on a semiconductor substrate; a second silicon pillar formed on the first silicon pillar; a first insulator surrounding a part of a surface of the second silicon pillar; a gate surrounding the first insulator; a third silicon pillar formed on the second silicon pillar; a first silicide surrounding a part of a surface of the first silicon pillar; and a second silicide surrounding a part of a surface of the third silicon pillar, wherein each of a contact resistance formed by the first silicide and the first silicon pillar, and a contact resistance formed by the second silicide and the third silicon pillar, is less than a reference resistance of the semiconductor device.

The present invention can provide a semiconductor device capable of solving problems of increase in power consumption and lowering in operation speed due to an increase in parasitic resistance of an SGT, to achieve high-speed SGT operation and low power consumption.

EXPLANATION OF CODES

| | |
|---|---|
| 100, 110: | semiconductor substrate |
| 210: | gate |
| 310: | gate insulating layer |
| 410, 420, 430, 440: | contact |
| 510, 520, 530, 540: | high-concentration impurity diffusion layer |
| 610: | inter-layer insulating film |
| 710, 720: | silicide |
| 810, 820: | silicon pillar |
| 910: | element-isolation insulating film |
| 1010: | high-resistance region |
| 1110: | sidewall oxide film |
| 1210: | contact-hole etching stopper layer |
| 1310: | source |
| 1410: | drain |
| 1610: | channel region |
| 1710: | metal line portion |
| 1810: | Al |
| 1910: | convex-shaped semiconductor |

## Claims

1. A semiconductor device comprising: a first silicon pillar formed on a semiconductor substrate; a second silicon pillar formed on the first silicon pillar; a first insulator surrounding a part of a surface of the second silicon pillar; a gate surrounding the first insulator; a third silicon pillar formed on the second silicon pillar; a first silicide surrounding a part of a surface of the first silicon pillar; and a second silicide surrounding a part of a surface of the third silicon pillar, wherein each of a contact resistance formed by the first silicide and the first silicon pillar, and a contact resistance formed by the second silicide and the third silicon pillar, is less than a reference resistance of the semiconductor device.

2. A semiconductor device comprising: a second silicon pillar formed on a semiconductor substrate; a first insulator surrounding a part of a surface of the second silicon pillar; a gate surrounding the first insulator; a third silicon pillar formed on the second silicon pillar; and a second silicide surrounding a part of a surface of the third silicon pillar, wherein a contact resistance formed by the second silicide and the third silicon pillar is less than a reference

resistance of the semiconductor device.

3. A semiconductor device comprising: a first silicon pillar formed on a semiconductor substrate; a second silicon pillar formed on the first silicon pillar; a first insulator surrounding a part of a surface of the second silicon pillar; a gate surrounding the first insulator; and a first silicide surrounding a part of a surface of the first silicon pillar, wherein a contact resistance formed by the first silicide and the first silicon pillar is less than a reference resistance of the semiconductor device.

4. A semiconductor device comprising: a first silicon pillar formed on a semiconductor substrate; a second silicon pillar formed on the first silicon pillar; a first insulator surrounding a part of a surface of the second silicon pillar; a gate surrounding the first insulator; a third silicon pillar formed on the second silicon pillar; a first silicide surrounding a part of a surface of the
first silicon pillar; and a second silicide surrounding a part of a surface of the third silicon pillar, wherein a diameter W1 (cm) and a height dimension L1 (cm) of the first silicon pillar, and a diameter W2 (cm) and a height dimension L2 (cm) of the third silicon pillar, satisfy the following relations:

$$\frac{1}{W1^{3/2}}\coth\left(\frac{L1}{W1^{1/2}\cdot 1.1e-3}\right) < 4.3e10$$

5. A semiconductor device comprising: a second silicon pillar formed on a semiconductor substrate; a first insulator surrounding a part of a surface of the second silicon pillar; a gate surrounding the first insulator; a third silicon pillar formed on the second silicon pillar; and a second silicide surrounding a part of a surface of the third silicon pillar, wherein a diameter W2 (cm) and a height dimension L2 (cm) of the third silicon pillar satisfy the following relation:

$$\frac{1}{W2^{3/2}}\coth\left(\frac{L2}{W2^{1/2}\cdot 1.1e-3}\right) < 4.3e10$$

6. A semiconductor device comprising: a first silicon pillar formed on a semiconductor substrate; a second silicon pillar formed on the first silicon pillar; a first insulator surrounding a part of a surface of the second silicon pillar; a gate surrounding the first insulator; and a first silicide surrounding a part of a surface of the first silicon pillar, wherein a diameter W1 (cm) and a height dimension L1 (cm) of the first silicon pillar satisfy the following relation:

$$\frac{1}{W1^{3/2}}\coth\left(\frac{L1}{W1^{1/2}\cdot 1.1e-3}\right) < 4.3e10$$

7. The semiconductor device as defined in any one of claims 1 to 6, wherein each of the first silicide and the second silicide is one selected from the group consisting of nickel (Ni) silicide, platinum (Pt) silicide, erbium (Er) silicide, ytterbium (Yb) silicide and a combination of two or
, and

$$\frac{1}{W2^{3/2}}\coth\left(\frac{L2}{W2^{1/2}\cdot 1.1e-3}\right) < 4.3e10$$

more thereof.

**8.** The semiconductor device as defined in any one of claims 1 to 7, wherein each of the first silicon pillar and the third silicon pillar includes a high-concentration impurity region.

**Amended claims under Art. 19.1 PCT**

**1.** A semiconductor device comprising: a first silicon pillar formed on a semiconductor substrate; a second silicon pillar formed on the first silicon pillar; a first insulator surrounding a part of a surface of the second silicon pillar; a gate surrounding the first insulator; a third silicon pillar formed on the second silicon pillar; a first silicide formed at least on a side of the first silicon pillar; and a second silicide formed at least on a side of the third silicon pillar, wherein each of a contact resistance formed by the first silicide and the first silicon pillar, and a contact resistance formed by the second silicide and the third silicon pillar, is less than a reference resistance of the semiconductor device.

**2.** A semiconductor device comprising: a second silicon pillar formed on a semiconductor substrate; a first insulator surrounding a part of a surface of the second silicon pillar; a gate surrounding the first insulator; a third silicon pillar formed on the second silicon pillar; and a second silicide formed at least on a side of the third silicon pillar, wherein a contact resistance formed by the second silicide and the third silicon pillar is less than a reference resistance of the semiconductor device.

**3.** A semiconductor device comprising: a first silicon pillar formed on a semiconductor substrate; a second silicon pillar formed on the first silicon pillar; a first insulator surrounding a part of a surface of the second silicon pillar; a gate surrounding the first insulator; and a first silicide formed at least on a side of the first silicon pillar, wherein a contact resistance formed by the first silicide and the first silicon pillar is less than a reference resistance of the semiconductor device.

**4.** A semiconductor device comprising: a first silicon pillar formed on a semiconductor substrate; a second silicon pillar formed on the first silicon pillar; a first insulator surrounding a part of a surface of the second silicon pillar; a gate surrounding the first insulator; a third silicon pillar formed on the second silicon pillar; a first silicide formed at least on a side of the first silicon pillar; and a second silicide formed at least on a side of the third silicon pillar, wherein a diameter W1 (cm) and a height dimension L1 (cm) of the first silicon pillar, and a diameter W2 (cm) and a height dimension L2 (cm) of the third silicon pillar, satisfy the following relations:

$$\frac{1}{W1^{3/2}}\coth\left(\frac{L1}{W1^{1/2}\cdot 1.1e-3}\right) < 4.3e10$$

, and

$$\frac{1}{W2^{3/2}}\coth\left(\frac{L2}{W2^{1/2}\cdot 1.1e-3}\right) < 4.3e10$$

**5.** A semiconductor device comprising: a second silicon pillar formed on a semiconductor substrate; a first insulator surrounding a part of a surface of the second silicon pillar; a gate surrounding the first insulator; a third silicon pillar formed on the second silicon pillar; and a second silicide formed at least on a side of the third silicon pillar, wherein a diameter W2 (cm) and a height dimension L2 (cm) of the third silicon pillar satisfy the following relation:

$$\frac{1}{W2^{3/2}}\coth\left(\frac{L2}{W2^{1/2}\cdot 1.1e-3}\right) < 4.3e10$$

6. A semiconductor device comprising: a first silicon pillar formed on a semiconductor substrate; a second silicon pillar formed on the first silicon pillar; a first insulator surrounding a part of a surface of the second silicon pillar; a gate surrounding the first insulator; and a first silicide formed at least on a side of the first silicon pillar, wherein a diameter W1 (cm) and a height dimension L1 (cm) of the first silicon pillar satisfy the following relation:

$$\frac{1}{W1^{3/2}}\coth\left(\frac{L1}{W1^{1/2}\cdot 1.1e-3}\right) < 4.3e10$$

7. The semiconductor device as defined in any one of claims 1 to 6, wherein each of the first silicide and the second silicide is one selected from the group consisting of nickel (Ni) silicide, platinum (Pt) silicide, erbium (Er) silicide, ytterbium (Yb) silicide and a combination of two or more thereof.

8. The semiconductor device as defined in any one of claims 1 to 7, wherein each of the first silicon pillar and the third silicon pillar includes a high-concentration impurity r egion.

FIG. 1

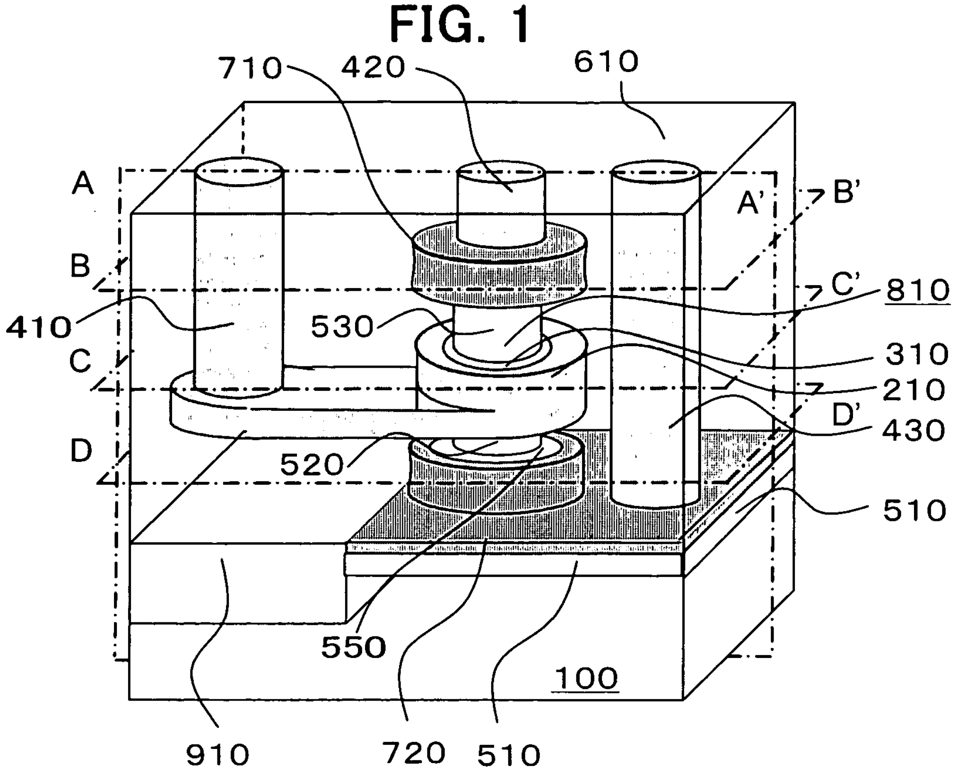
710
420
610
A
A'
B'
B
C'
810
410
530
C
310
210
D'
430
D
520
510
550
100
910
720
510

FIG. 2

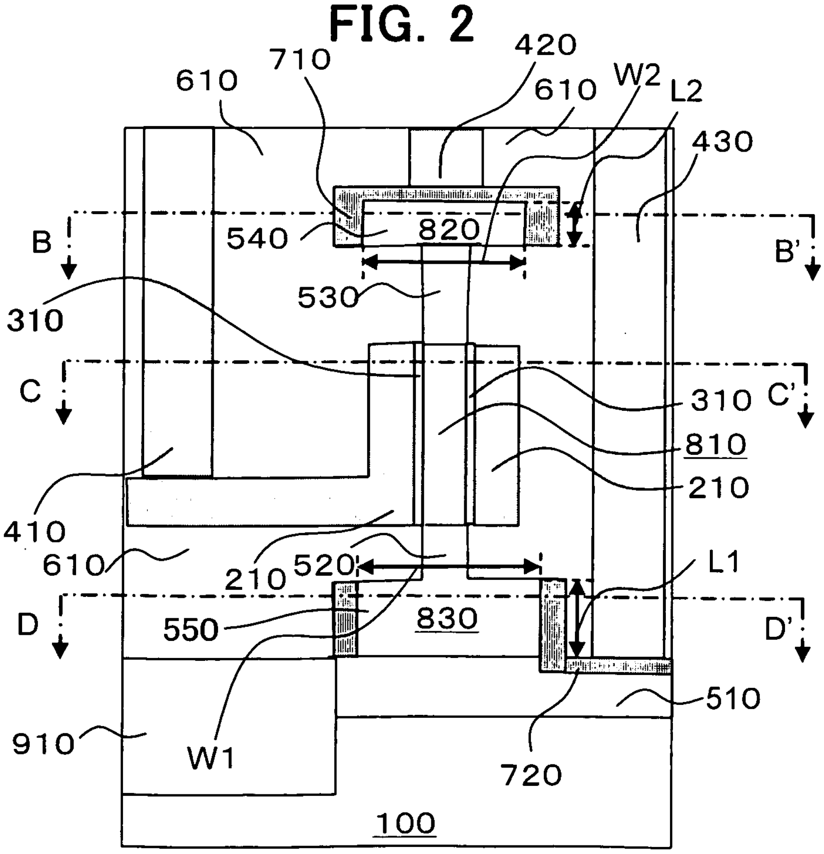
710
420
610
610
W2
L2
430
B
540
820
B'
530
310
C
310
C'
810
210
410
610
210
520
L1
D
550
830
D'
510
910
W1
720
100

FIG. 3

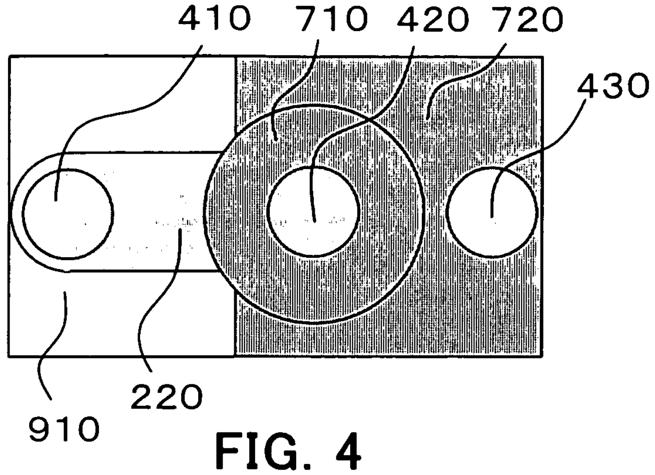


FIG. 4

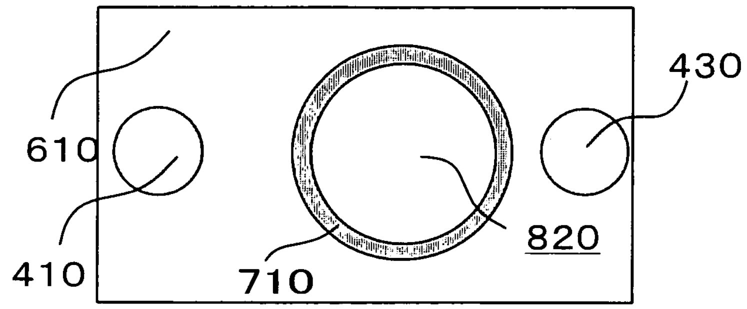


FIG. 5

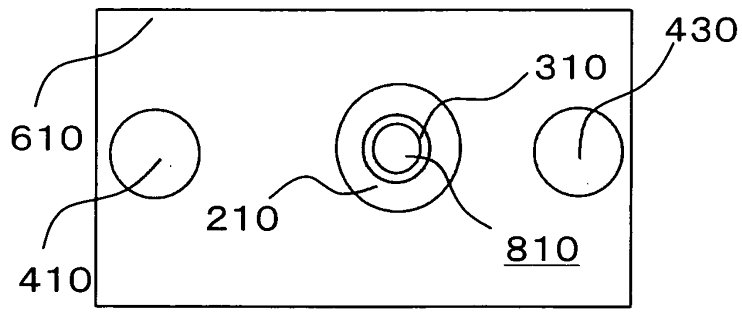


FIG. 6

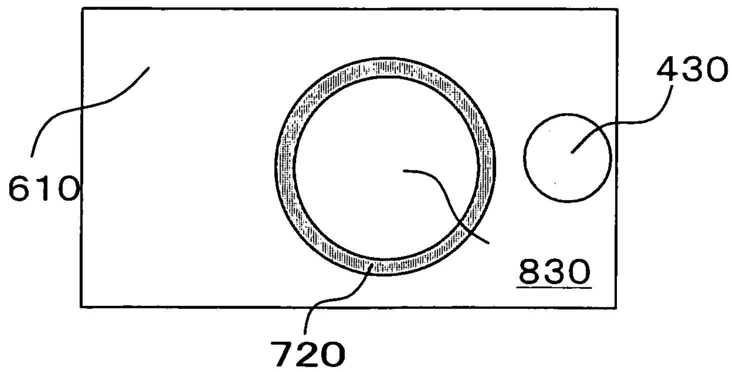

FIG. 7

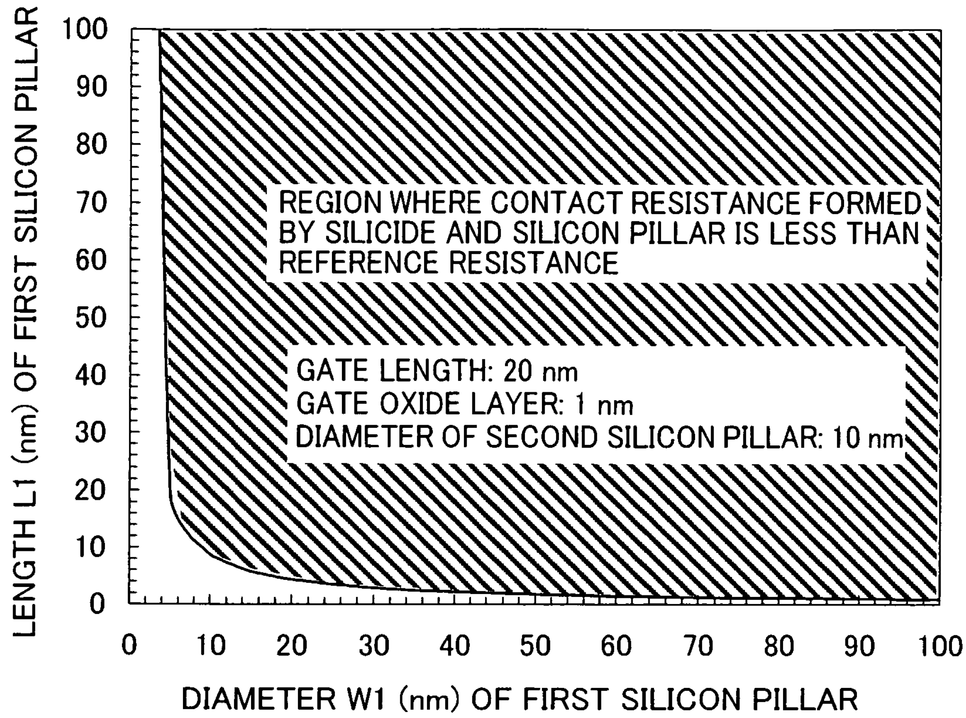
REGION WHERE CONTACT RESISTANCE FORMED BY SILICIDE AND SILICON PILLAR IS LESS THAN REFERENCE RESISTANCE
GATE LENGTH: 20 nm
GATE OXIDE LAYER: 1 nm
DIAMETER OF SECOND SILICON PILLAR: 10 nm
LENGTH L1 (nm) OF FIRST SILICON PILLAR
0 10 20 30 40 50 60 70 80 90 100
DIAMETER W1 (nm) OF FIRST SILICON PILLAR

FIG. 8

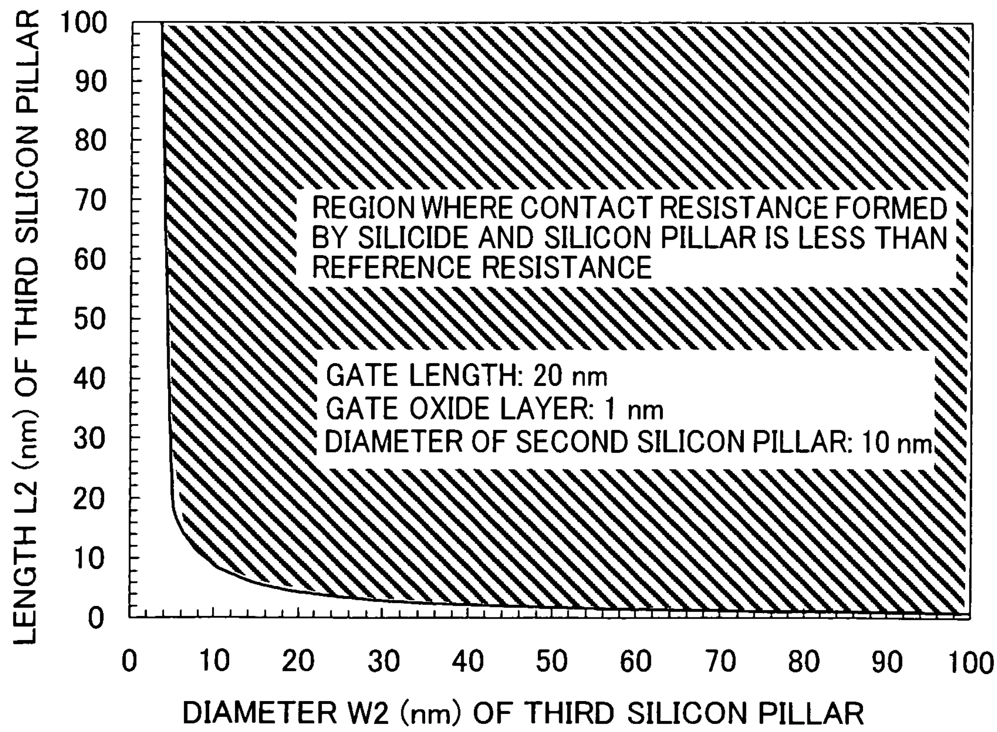
REGION WHERE CONTACT RESISTANCE FORMED BY SILICIDE AND SILICON PILLAR IS LESS THAN REFERENCE RESISTANCE
GATE LENGTH: 20 nm
GATE OXIDE LAYER: 1 nm
DIAMETER OF SECOND SILICON PILLAR: 10 nm
LENGTH L2 (nm) OF THIRD SILICON PILLAR
0 10 20 30 40 50 60 70 80 90 100
DIAMETER W2 (nm) OF THIRD SILICON PILLAR

FIG. 9

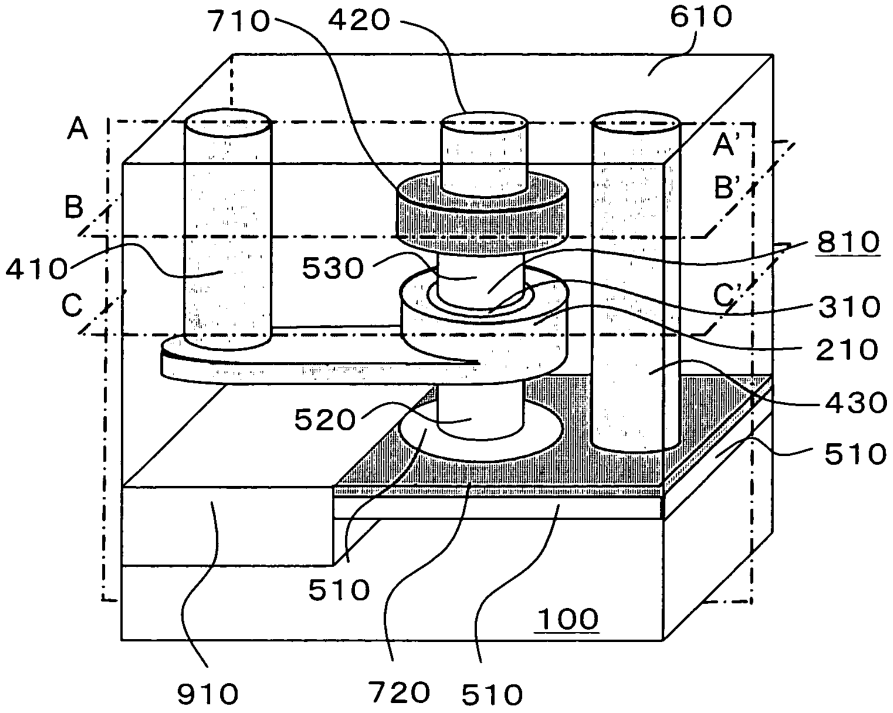
710
420
610
A
A'
B'
B
810
410
530
C
C'
310
210
430
520
510
510
100
910
720
510

FIG. 10

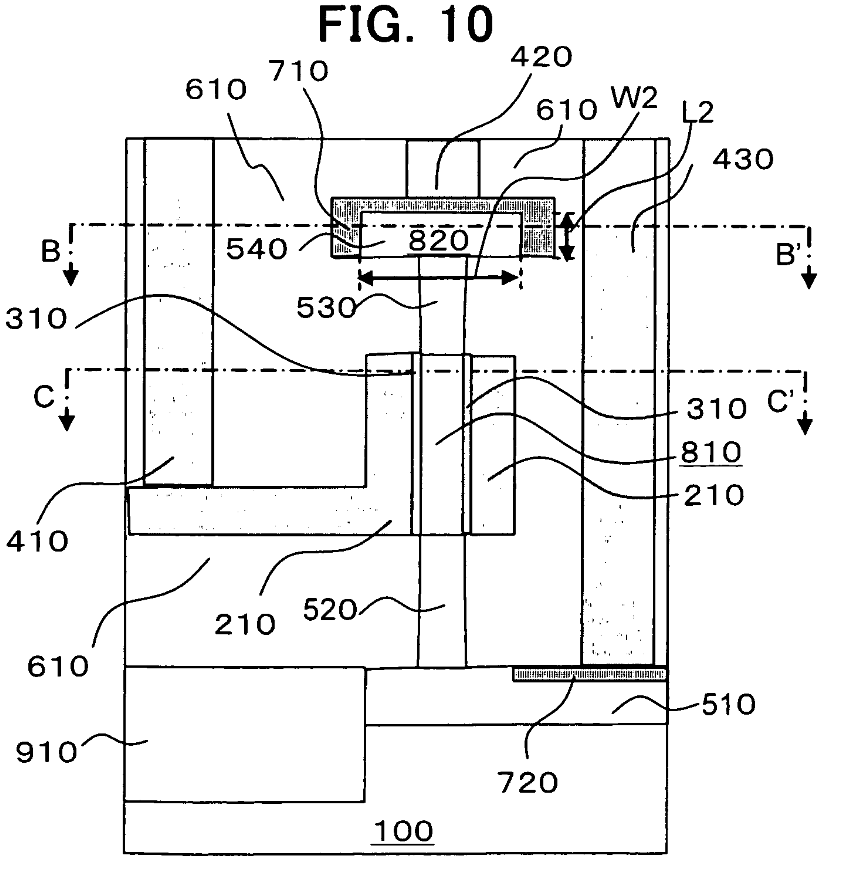
420
710
610
610
W2
L2
430
B
540
820
B'
530
310
C
C'
310
810
210
410
210
520
610
510
910
720
100

FIG. 11

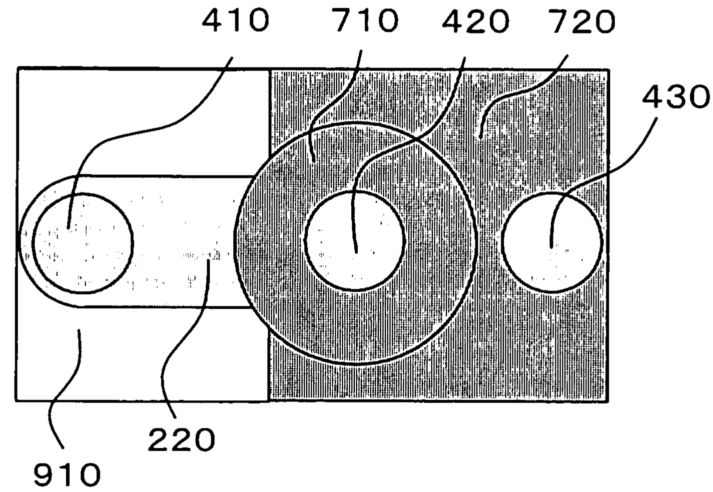


FIG. 12

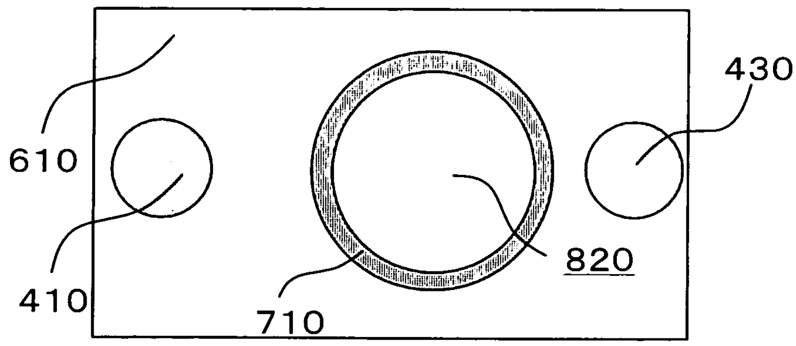


FIG. 13

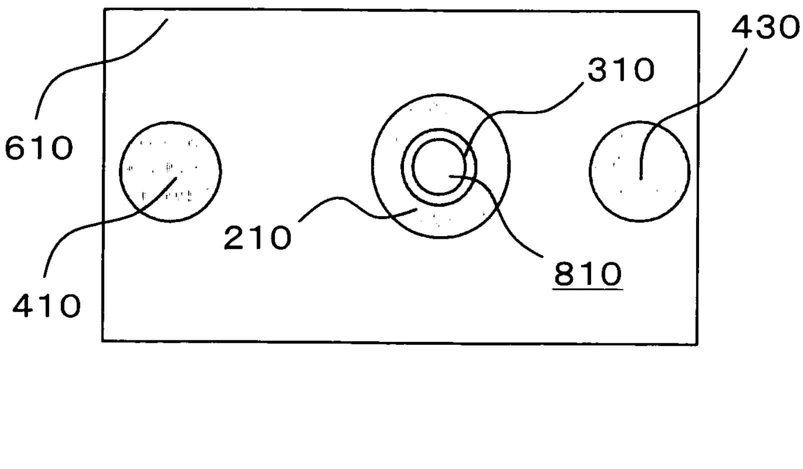

FIG. 14

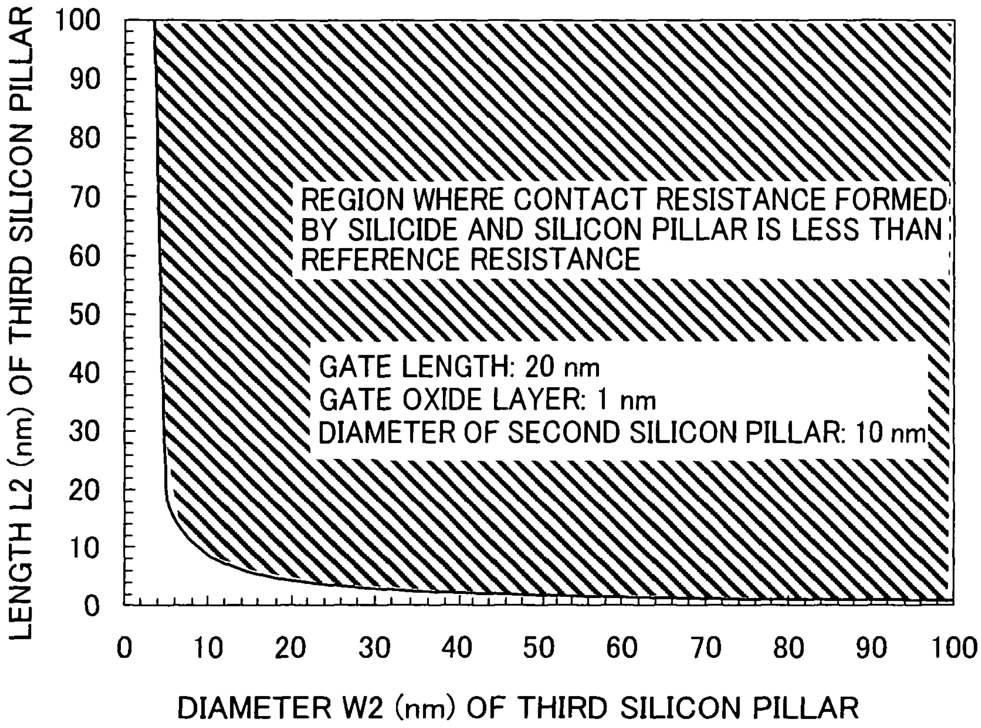

LENGTH L2 (nm) OF THIRD SILICON PILLAR
100
90
80
70
60
50
40
30
20
10
0
REGION WHERE CONTACT RESISTANCE FORMED BY SILICIDE AND SILICON PILLAR IS LESS THAN REFERENCE RESISTANCE
GATE LENGTH: 20 nm
GATE OXIDE LAYER: 1 nm
DIAMETER OF SECOND SILICON PILLAR: 10 nm
0 10 20 30 40 50 60 70 80 90 100
DIAMETER W2 (nm) OF THIRD SILICON PILLAR

# FIG. 15

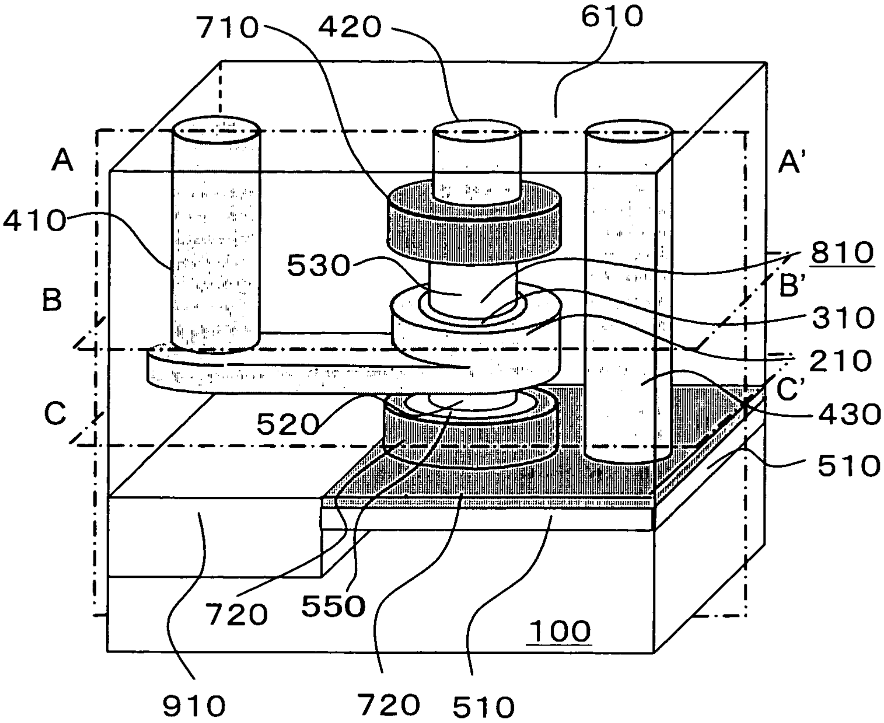
710
420
610
A
A'
410
530
810
B
B'
310
210
C
C'
430
520
510
720
550
100
910
720
510

# FIG. 16

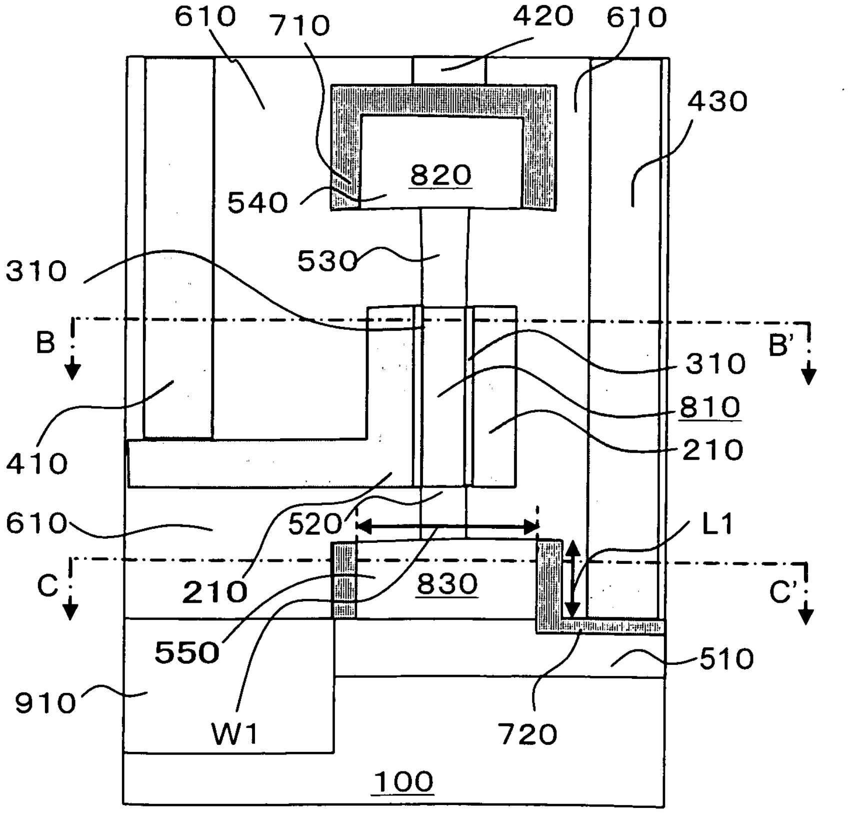
610
710
420
610
430
820
540
530
310
B
B'
310
810
210
410
610
520
L1
C
830
C'
210
550
510
910
W1
720
100

FIG. 17

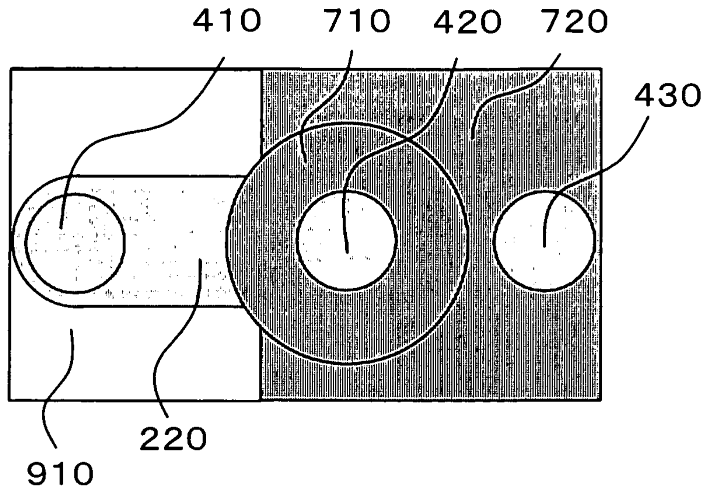


FIG. 18

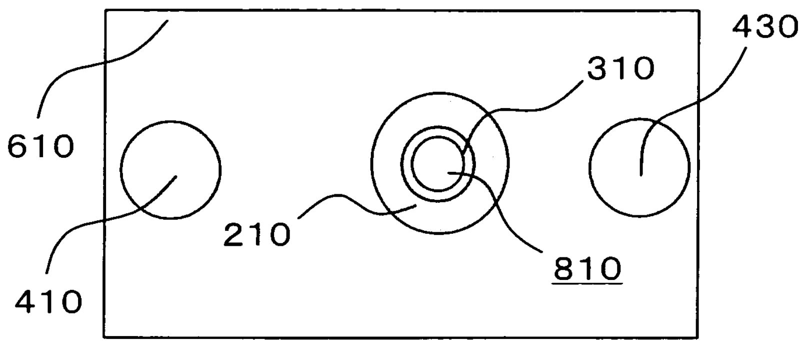


FIG. 19

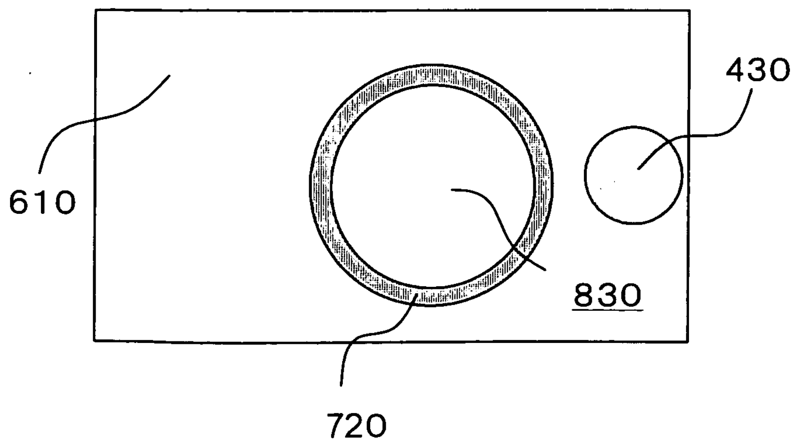

FIG. 20

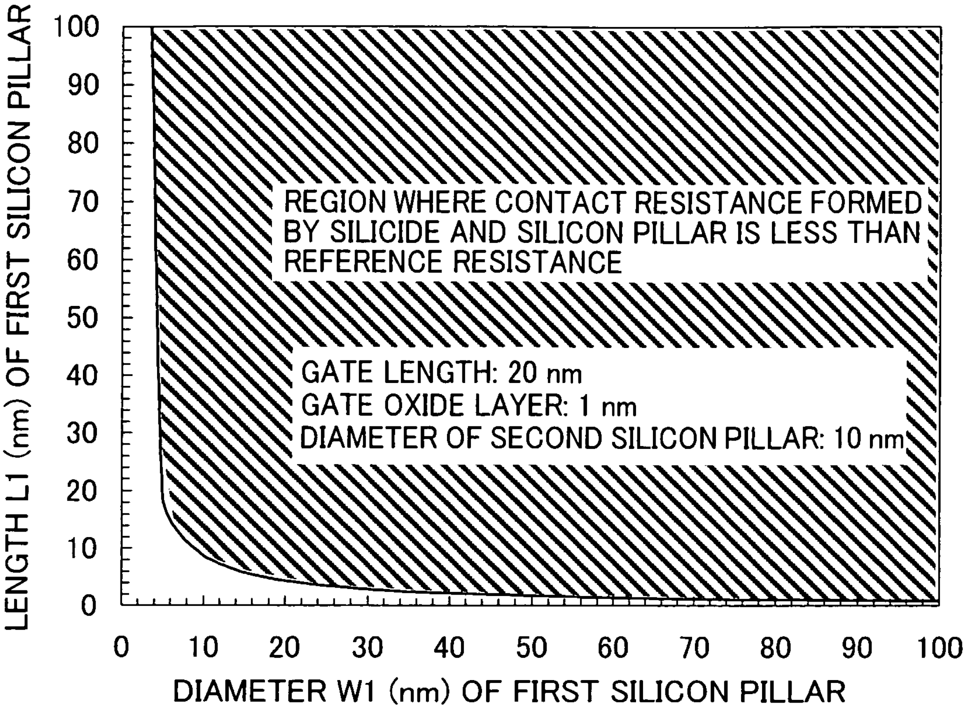
LENGTH L1 (nm) OF FIRST SILICON PILLAR
100
90
80
70
60
50
40
30
20
10
0
REGION WHERE CONTACT RESISTANCE FORMED BY SILICIDE AND SILICON PILLAR IS LESS THAN REFERENCE RESISTANCE
GATE LENGTH: 20 nm
GATE OXIDE LAYER: 1 nm
DIAMETER OF SECOND SILICON PILLAR: 10 nm
0 10 20 30 40 50 60 70 80 90 100
DIAMETER W1 (nm) OF FIRST SILICON PILLAR

FIG. 21

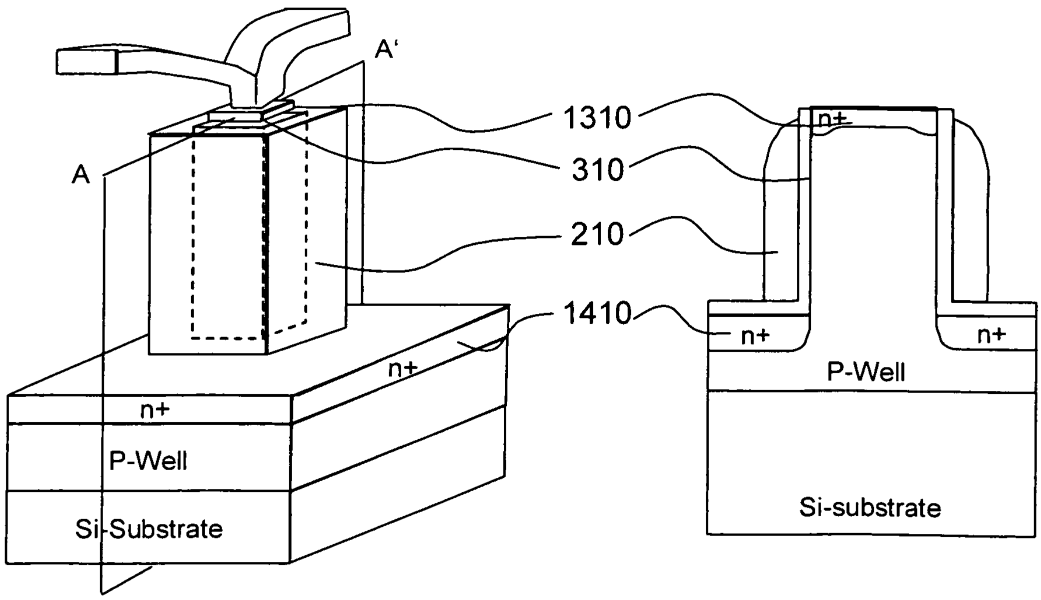
A
A'
1310
310
210
1410
n+
n+
P-Well
Si-Substrate
n+
n+
n+
P-Well
Si-substrate

FIG. 22

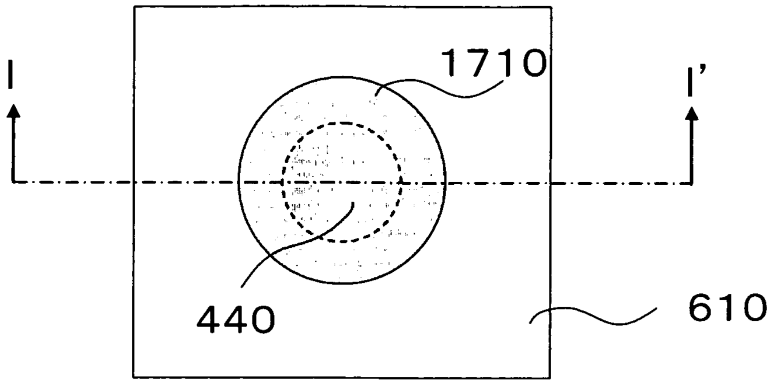


FIG. 23

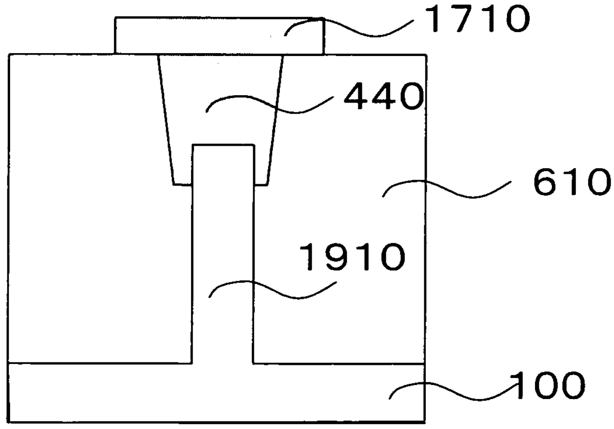

| INTERNATIONAL SEARCH REPORT | International application No. PCT/JP2007/073935 |
|---|---|

A. CLASSIFICATION OF SUBJECT MATTER
*H01L21/336*(2006.01)i, *H01L21/28*(2006.01)i, *H01L29/78*(2006.01)i

According to International Patent Classification (IPC) or to both national classification and IPC

B. FIELDS SEARCHED

Minimum documentation searched (classification system followed by classification symbols)
H01L21/336, H01L21/28, H01L29/78

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 3-114233 A (Oki Electric Industry Co., Ltd.), 15 May, 1991 (15.05.91), Page 2, lower left column, line 17 to page 4, lower left column, line 10; Figs. 1 to 3 & KR 217495 B1 & US 5136350 A & US 5155054 A | 1-8 |
| Y | JP 2006-261421 A (Toshiba Corp.), 28 September, 2006 (28.09.06), Par. Nos. [0012] to [0039]; Figs. 1 to 10 & US 2006/0208283 A1 | 1-8 |
| Y | JP 8-227997 A (Hitachi, Ltd.), 03 September, 1996 (03.09.96), Par. Nos. [0010] to [0022]; Figs. 1 to 11 (Family: none) | 1-8 |

☒ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 07 March, 2008 (07.03.08) | 18 March, 2008 (18.03.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2007/073935

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2000-68516 A (Sony Corp.), 03 March, 2000 (03.03.00), Par. Nos. [0018] to [0036]; Figs. 1 to 4 (Family: none) | 1-8 |
| Y | JP 2003-101012 A (Sony Corp.), 04 April, 2003 (04.04.03), Par. Nos. [0003] to [0005]; Fig. 8 (Family: none) | 2,5,7,8 |
| Y | JP 6-310730 A (Hitachi, Ltd.), 04 November, 1994 (04.11.94), Par. Nos. [0016] to [0052]; Figs. 1 to 12 (Family: none) | 1-8 |
| Y | JP 2007-123415 A (Sharp Corp.), 17 May, 2007 (17.05.07), Par. Nos. [0016], [0017] (Family: none) | 1-8 |
| A | JP 1-232755 A (Fujitsu Ltd.), 18 September, 1989 (18.09.89), Page 7, lower left column, line 1 to page 8, lower right column, line 15; Figs. 3, 4 (Family: none) | 1-8 |
| A | JP 2006-294995 A (NEC Corp.), 26 October, 2006 (26.10.06), Par. Nos. [0106] to [0125]; Figs. 12 to 14 (Family: none) | 1-8 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2007123415 A

### Non-patent literature cited in the description


- **H.Takato et al.** *IEEE transaction on electron device,* March 1991, vol. 38 (3), 573-578